(19) Europäisches Patentamt
European Patent Office
Office européen des brevets

(11) **EP 4 312 281 A1**

(12) **EUROPEAN PATENT APPLICATION**

(43) Date of publication:
**31.01.2024 Bulletin 2024/05**

(21) Application number: **22186607.2**

(22) Date of filing: **25.07.2022**

(51) International Patent Classification (IPC):
***H01L 51/50*** *(2006.01)* ***H01L 51/52*** *(2006.01)*

(52) Cooperative Patent Classification (CPC):
**H10K 50/165; H10K 50/82;** H10K 85/615; H10K 85/654

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Novaled GmbH**
**01099 Dresden (DE)**

(72) Inventors:
- **HUANG, Qiang**
  **01099 Dresden (DE)**
- **PAVICIC, Domagoj**
  **01099 Dresden (DE)**
- **LUSCHTINETZ, Regina**
  **01099 Dresden (DE)**
- **RUNGE, Steffen**
  **01099 Dresden (DE)**

(74) Representative: **Bittner, Thomas L.**
**Boehmert & Boehmert**
**Anwaltspartnerschaft mbB**
**Pettenkoferstrasse 22**
**80336 München (DE)**

(54) **ORGANIC ELECTRONIC DEVICE AND DISPLAY DEVICE COMPRISING THE SAME**

(57) The present invention relates to an organic electronic device comprising an anode, a cathode, a first emission layer and a first electron transport layer, wherein - the first emission layer is arranged between the anode and the cathode;- the first electron transport layer is arranged between first emission layer and the cathode;- the first electron transport layer comprises a first electron transport matrix compound and a metal salt;- the first electron transport matrix compound comprises a phosphine oxide group;- the cathode comprises silver and/or a silvercontaining alloy; and- the first electron transport layer is in direct contact with the cathode; and to a display device comprising the organic electronic device.

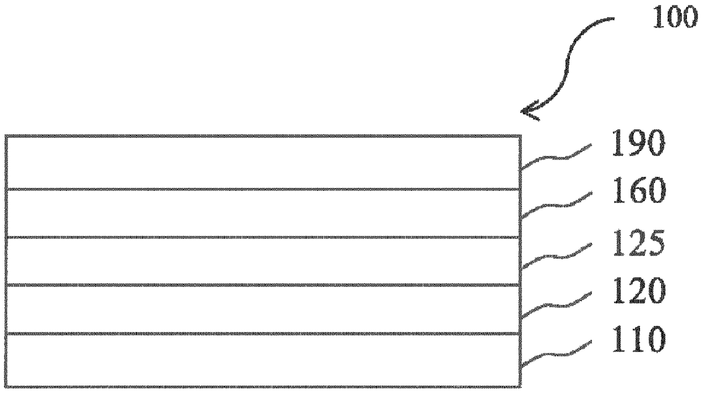


Fig.1

EP 4 312 281 A1

## Description

The present invention relates to an organic electronic device and to a display device comprising the same.

BACKROUND OF THE INVENTION

Organic electronic devices, such as organic light-emitting diodes OLEDs, which are selfemitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the organic semiconductor layer, and among them, may be affected by characteristics of an organic material of the organic semiconductor layer.

Particularly, development of an organic semiconductor layer being capable of increasing electron mobility and simultaneously increasing electrochemical stability is needed so that the organic electronic device, such as an organic light emitting diode, may be applied to a large-size flat panel display.

Further, development of an organic semiconductor layer being capable to have an extended life span at higher current density and thereby at higher brightness is needed. In particular the development of an organic semiconductor material or semiconductor layer is needed with respect to lowering the operating voltage, which is important for reducing power consumption and increasing battery life, for example of a mobile display device.

There remains a need to improve performance of organic electronic devices, such as tandem OLED devices, in particular to achieve increased efficiency.

It is, therefore, the object of the present invention to provide an organic light emitting diode overcoming drawbacks of the prior art, in particular tandem OLED device with improved efficiency.

DISCLOSURE

This object is achieved by an organic electronic device comprising an anode, a cathode, a first emission layer and a first electron transport layer, wherein

- the first emission layer is arranged between the anode and the cathode;
- the first electron transport layer is arranged between first emission layer and the cathode;
- the first electron transport layer comprises a first electron transport matrix compound and a metal salt;
- the first electron transport matrix compound comprises a phosphine oxide group;
- the cathode comprises silver and/or a silver-containing alloy; and
- the first electron transport layer is in direct contact with the cathode.

This object is further achieved by a display device comprising the organic electronic device according to the invention.

Surprisingly, it was found that the organic electronic device according to the invention solves the problem underlying the present invention by showing an improved efficiency while the operating voltage is basically kept constant.

<u>Cathode</u>

The cathode has a thickness from 1 to 20 nm, preferably 5 to 18 nm, even more preferably 8 to 16 nm, even more preferably 10 to 15 nm, most preferably 12 to 14 nm.

The cathode comprises silver and/or a silver-containing alloy. The cathode may comprise silver and/or the silver-containing alloy in a total amount of at least 50 wt.-% with respect to the total weight of the cathode. The cathode

may comprise silver and/or the silver-containing alloy in a total amount of at least 70 wt.-% with respect to the total weight of the cathode. The cathode may comprise silver and/or the silver-containing alloy in a total amount of at least 80 wt.-% with respect to the total weight of the cathode. The cathode may comprise silver and/or the silver-containing alloy in a total amount of at least 90 wt.-% with respect to the total weight of the cathode. The cathode may comprise silver and/or the silver-containing alloy in a total amount of at least 95 wt.-% with respect to the total weight of the cathode. The cathode may comprise silver and/or the silver-containing alloy in a total amount of at least 98 wt.-% with respect to the total weight of the cathode. The cathode may comprise silver and/or the silver-containing alloy in a total amount of at least 99 wt.-% with respect to the total weight of the cathode. The cathode may consist of the silver and/or of the silver-containing alloy.

The cathode may comprise silver in an amount of at least 50 vol.-%, preferably at least 70 vol.- %; more preferably 80 vol.-%, most -even more preferred at least 90 vol.-%, most preferred at least 95 vol.-% with respect to the total volume of the cathode, respectively.

The cathode may comprise a Mg-Ag alloy. The cathode may comprise the Mg-Ag alloy in a total amount of at least 50 wt.-% with respect to the total weight of the cathode. The cathode may comprise the Mg-Ag alloy in a total amount of at least 70 wt.-% with respect to the total weight of the cathode. The cathode may comprise the Mg-Ag alloy in a total amount of at least 80 wt.- % with respect to the total weight of the cathode. The cathode may comprise the Mg-Ag alloy in a total amount of at least 90 wt.-% with respect to the total weight of the cathode. The cathode may comprise the Mg-Ag alloy in a total amount of at least 95 wt.-% with respect to the total weight of the cathode. The cathode may comprise the Mg-Ag alloy in a total amount of at least 98 wt.-% with respect to the total weight of the cathode. The cathode may comprise the Mg-Ag alloy in a total amount of at least 99 wt.-% with respect to the total weight of the cathode. The cathode may consist of the Mg-Ag alloy.

The cathode may be free of Yb. The cathode does not include an electron injection layer.

## First electron transport layer

The first electron transport layer may have a thickness of more than 5 nm, preferably more than 10 nm, more preferably more than 20 nm, most preferred more than 30 nm. The first electron transport layer may have a thickness of less than 100 nm, preferably of less than 70 nm, more preferably of less than 50 nm, most preferred of less than 40 nm. The first electron transport layer may have a thickness from 5 to 100 nm, preferably from 10 to 70 nm, more preferred from 20 to 50 nm, most preferred from 30 to 40 nm.

The first electron transport layer comprises a first electron transport matrix compound and a metal salt. The first electron transport layer may comprise the first electron transport matrix compound and the metal salt in a total amount of at least 50 wt.-% with respect to the total weight of the first electron transport layer. The first electron transport layer may comprise the first electron transport matrix compound and the metal salt in a total amount of at least 70 wt.-% with respect to the total weight of the first electron transport layer. The first electron transport layer may comprise the first electron transport matrix compound and the metal salt in a total amount of at least 80 wt.-% with respect to the total weight of the first electron transport layer. The first electron transport layer may comprise the first electron transport matrix compound and the metal salt in a total amount of at least 90 wt.-% with respect to the total weight of the first electron transport layer. The first electron transport layer may comprise the first electron transport matrix compound and the metal salt in a total amount of at least 95 wt.-% with respect to the total weight of the first electron transport layer. The first electron transport layer may comprise the first electron transport matrix compound and the metal salt in a total amount of at least 98 wt.-% with respect to the total weight of the first electron transport layer. The first electron transport layer may comprise the first electron transport matrix compound and the metal salt in a total amount of at least 99 wt.-% with respect to the total weight of the first electron transport layer. The first electron transport layer may consist of the first electron transport matrix compound and the metal salt.

The first electron transport layer may comprise the first electron transport matrix compound and the metal salt in a volume ratio from 10:90 to 90:10. The first electron transport layer may comprise the first electron transport matrix compound and the metal salt in a volume ratio from 20:80 to 80:20. The first electron transport layer may comprise the first electron transport matrix compound and the metal salt in a volume ratio from 30:70 to 70:30. The first electron transport layer may comprise the first electron transport matrix compound and the metal salt in a volume ratio from 35:65 to 65:35. The first electron transport layer may comprise the first electron transport matrix compound and the metal salt in a volume ratio from 40:60 to 60:40. The first electron transport layer may comprise the first electron transport matrix compound and the metal salt in a volume ratio of about 50:50.

It may be provided that an embodiment in which the first electron transport matrix compound has the following structure:

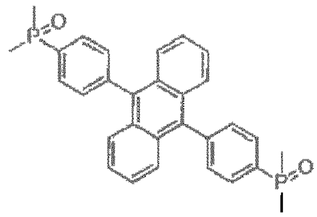

the metal salt is lithium tetra(1H-pyrazol-1-yl; the first electron transport matrix compound and the metal salt are present in a vol.-% ratio of 20:30; and the cathode consists of an alloy of Ag and Mg with a Ag:Mg vol.-ratio of 85:85; is excluded.

First electron transport matrix compound

The first electron transport matrix compound comprises a phosphine oxide group. In this regard, "phosphine oxide group" refers to a group in which a P=O group is bound to three other groups via single bonds to the P-atom. One of these three bindings can be a binding to the remaining structure of the first electron transport matrix compound. In this case, the phosphine oxide group has the following formula

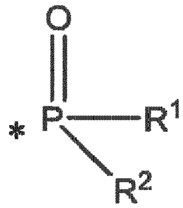

wherein "*" represents the position at which the phosphine oxide group is bound to the remaining structure of the first electron transport matrix compound via a single bond and $R^1$ and $R^2$ represent two further groups.

It may be provided that the first electron transport matrix compound comprises exactly one phosphine oxide group, that is, that each molecule of the first electron transport matrix compound in the first electron transport layer comprises exactly one phosphine oxide group. That is, it may be provided that the first electron transport matrix compound comprises two or more phosphine oxide groups (per molecule).

The first electron transport matrix compound may comprise at least one aromatic heterocyclic group. The aromatic heterocyclic group may comprise at least one nitrogen atom, preferably at least two nitrogen atoms. The aromatic heterocyclic group may be selected from the group consisting of diazine, triazine, diazanaphtalene, diazaanthracene and diazaphenanthrene. The aromatic heterocyclic group may be selected from the group consisting of diazine and triazine.

The phosphine oxide group may comprise a P=O moiety directly bonded to two sp3 hybridized C-atoms. That is, the phosphine oxide group may have the formula

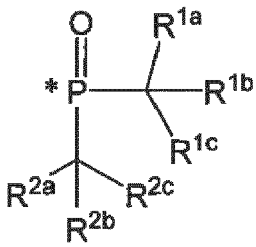

wherein "*" represents the position at which the phosphine oxide group is bound to the remaining structure of the first electron transport matrix compound via a single bond and $R^{1a}$, $R^{1b}$, $R^{1c}$, $R^{2a}$, $R^{2b}$, and $R^{2c}$ are independently selected from hydrogen, hydrocarbyl or heteroatom-containing hydrocarbyl.

The phosphine oxide group may be a dialkylphosphine oxide group. The phosphine oxide group may be a di-$C_1$ to $C_{16}$-alkyl phosphine oxide group. The phosphine oxide group may be a di-$C_1$ to $C_8$-alkyl phosphine oxide group. The phosphine oxide group may be a di-$C_1$ to $C_4$-alkyl phosphine oxide group. The phosphine oxide group may be a dimethylphosphine oxide group.

The first electron transport matrix compound may be a compound of formula (1)

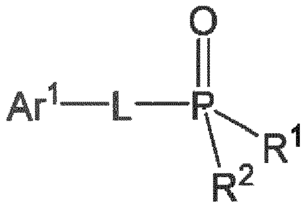

(1)

wherein

$Ar^1$ is selected from unsubstituted or substituted $C_2$ to $C_{60}$ heteroarylene, and wherein the substituted $C_2$ to $C_{60}$ heteroarylene comprises at least about one to about six substituents,
wherein the substituent of the substituted $C_2$ to $C_{60}$ heteroarylene are independently selected from $C_1$ to $C_{12}$ alkyl, $C_1$ to $C_{12}$ alkoxy, CN, OH, halogen, $C_6$ to $C_{36}$ arylene, or $C_2$ to $C_{25}$ heteroarylene;

L is selected from a single bond, $C_1$ to $C_4$ alkyl, substituted or unsubstituted $C_6$ to $C_{36}$ arylene,
wherein the substituent of substituted $C_6$ to $C_{36}$ arylene is selected from $C_1$ to $C_{12}$ alkyl, and $C_6$ to $C_{18}$ arylene

$R^1$ and $R^2$ are independently selected from are independently substituted or unsubstituted $C_1$ to $C_{16}$ alkyl, wherein the substituent of substituted $C_1$ to $C_{16}$ alkyl is selected from $C_6$ to $C_{18}$ arylene or $C_2$ to $C_{12}$ heteroarylene;
wherein the compound of formula 1:

- comprises at least about 4 of $C_6$-arylene rings;
  and/or

- has a molecular mass of at least about 400 g/mol to about 1800 g/mol.

The compound of formula (1) may comprise at least about 4 to about 12 $C_6$-arylene rings, preferably at least about 5 to about 9 $C_6$-arylene rings, such as 6 to 8 $C_6$-arylene rings and/or 2 to 4 condensed $C_6$-arylene rings, such as 3 condensed $C_6$ arylene rings.

$Ar^1$ may be independently selected from the group consisting of $C_2$ to $C_{39}$ N-containing heteroaryl and $C_6$ to $C_{54}$ aryl, optionally $C_2$ to $C_{36}$ N-containing heteroaryl, and $C_6$ to $C_{48}$ aryl, optionally $C_3$ to $C_{30}$ N-containing heteroaryl and $C_6$ to $C_{42}$ aryl, optionally $C_3$ to $C_{27}$ N-containing heteroaryl and $C_6$ to $C_{36}$ aryl, optionally $C_3$ to $C_{24}$ N-containing heteroaryl and $C_6$ to $C_{30}$ aryl, and optionally $C_3$ to $C_{21}$ N-containing heteroaryl and $C_6$ to $C_{24}$ aryl. In this regard, it may be provided that a respective N-containing heteroaryl comprises one or more N-atoms as the only heteroatom(s).

$Ar^1$ may be independently selected from the group consisting of triazinyl, 1,2-diazinyl, 1,3-diazinyl, 1,4-diazinyl, quinazolinyl, benzoquinazolinyl, benzimidazolyl, quinolinyl, benzoquinolinyl benzoacridinyl, dibenzoacridinyl, fluoranthenyl, anthracenyl, naphthyl, triphenylenyl, phenanthrolinyl, and dinaphthofuranyl which may be substituted or unsubstituted, respectively.

$Ar^1$ may be independently selected from the group consisting of triazinyl, 1,2-diazinyl, 1,3-diazinyl, 1,4-diazinyl, quinazolinyl, benzoquinazolinyl, benzoacridinyl, dibenzoacridinyl, fluoranthenyl, anthracenyl, naphthyl, triphenylenyl, phenanthrolinyl, and dinaphthofuranyl which may be substituted or unsubstituted, respectively.

$Ar^1$ may be independently selected from the group consisting of triazinyl, 1,2-diazinyl, 1,3-diazinyl, 1,4-diazinyl, quinazolinyl, benzoquinazolinyl, benzoacridinyl, dibenzoacridinyl, fluoranthenyl which may be substituted or unsubstituted, respectively.

In case that $Ar^1$ is substituted, each substituent on $Ar^1$ may be independently selected from the group consisting of phenyl, naphthyl and biphenyl-yl. In case that $Ar^1$ is substituted, each substituent on X may be independently selected from the group consisting of phenyl and biphenyl-yl.

In the compound of formula (1), L may bond via a single bond directly on an aromatic heterocyclic ring of $Ar^1$. The aromatic heterocyclic ring of $Ar^1$ may comprise preferably about 1 to about 3 N-atoms, further preferred 2 to 3 N-atoms. The aromatic heterocyclic ring of $Ar^1$ may be selected from the group consisting of diazine, triazine, the N-containing ring of diazanaphtalene, the N-containing ring of diazaanthracene and the N-containing ring of diazaphenanthrene. The aromatic heterocyclic ring of $Ar^1$ may be selected from the group consisting of diazine and triazine.

$Ar^1$ may comprise at least one N-heteroaryl group selected from the group comprising a triazine, quinazoline, quinoline, benzimidazole, benzothiazole, benzo[4,5]thieno[3,2-d]pyrimidine, pyrimidine and pyridine, most preferred $Ar^1$ comprises a triazine or pyrimidine.

$Ar^1$ may have one of the following structures,

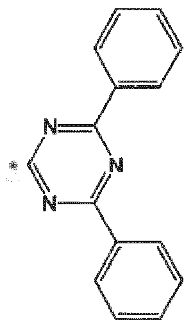
;
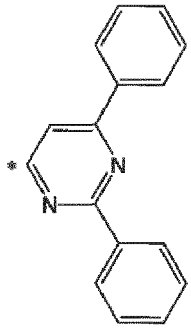

wherein "*" represents the binding position to L.

L may be $C_6$ to $C_{54}$ aryl, optionally $C_6$ to $C_{48}$ aryl, optionally $C_6$ to $C_{42}$ aryl, optionally $C_6$ to $C_{36}$ aryl, optionally $C_6$ to $C_{30}$ aryl, and optionally $C_6$ to $C_{24}$ aryl.

L may comprise a system of two or more anellated aromatic rings, preferably three or more anellated aromatic rings, such as three aromatic rings.

L may have the structure 1*-$L^a$-$L^b$-$L^c$-2*, wherein $L^a$ and $L^c$ are phenylene and $L^b$ is $C_6$ to $C_{42}$ aryl, wherein L is connected via a single bond to $Ar^1$ at "1*"; and L is connected via a single bond to P at "2*".

L may have the structure 1*-$L^a$-$L^b$-$L^c$-2*, wherein $L^a$ and $L^c$ are meta-phenylene and $L^b$ is $C_6$ to $C_{24}$ aryl comprising 2 or 3 annellated rings, wherein L is connected via a single bond to $Ar^1$ at "1*"; and L is connected via a single bond to P at "2*".

L may be selected from the following groups L1 to L11

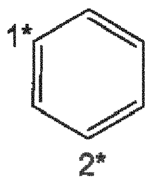
(L1);
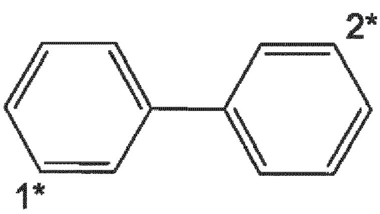
(L2);
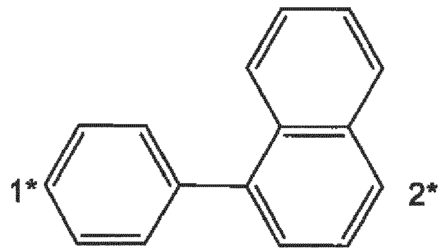
(L3);

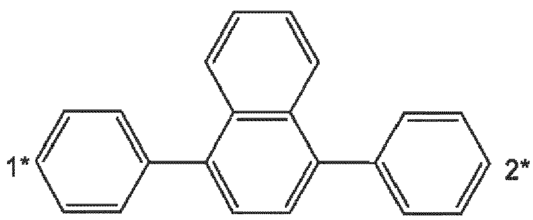
(L4);
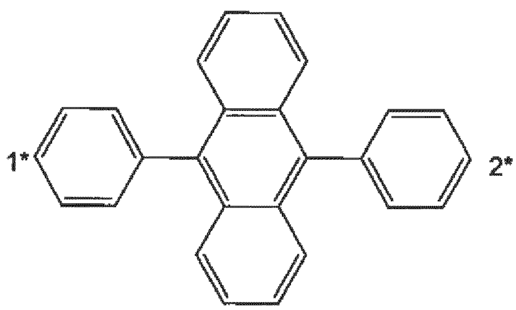
(L5);

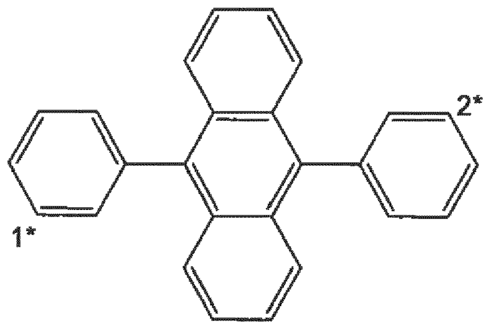
(L6);
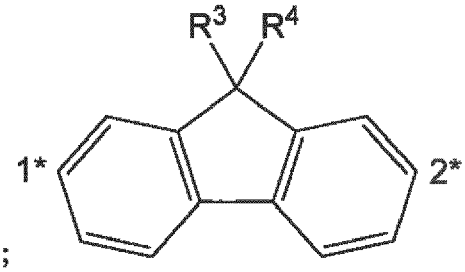
(L7);

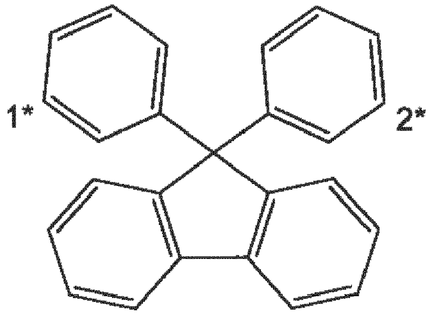
(L8);
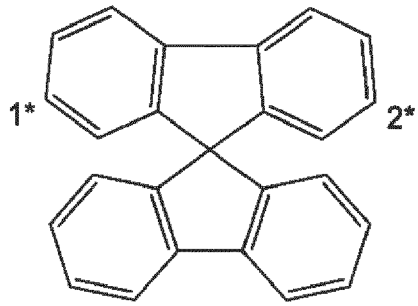
(L9);

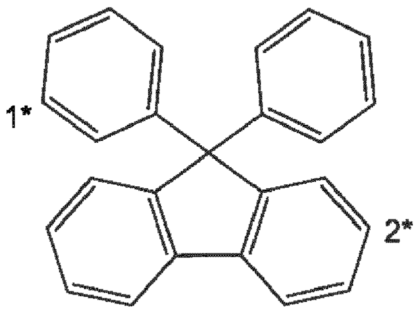
(L10);
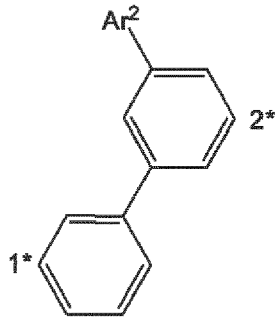
(L11)

wherein

$R^3$ and $R^4$ are independently selected from $C_1$ to $C_{16}$ alkyl, substituted or unsubstituted $C_6$ to $C_{36}$ arylene, $C_2$ to $C_{25}$ heteroarylene;

$Ar^7$ is selected from $C_{10}$ to $C_{16}$ aryl;

L is connected via a single bond to $Ar^1$ at "1*"; and

L is connected via a single bond to P at "2*".

$R^1$ and R2 may be independently $C_1$ to $C_{16}$-alkyl, preferably $C_1$ to $C_8$-alkyl, more preferred $C_1$ to $C_4$-alkyl, further preferred $C_1$ to $C_2$-alkyl, most preferred methyl.

The first electron transport matrix compound may have one of the following formulas E1 or E2

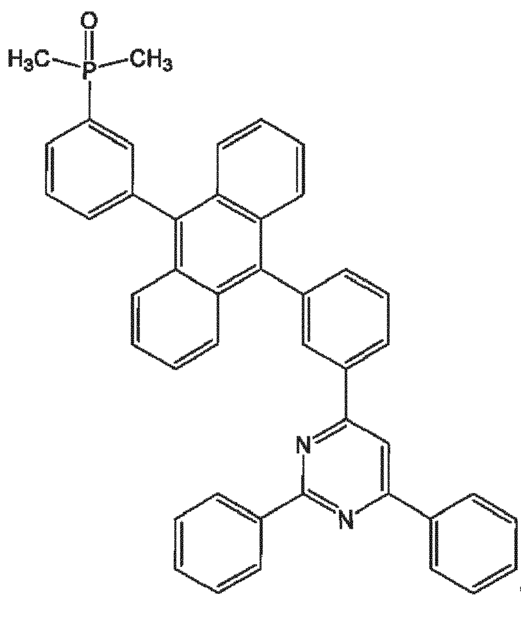

(E1)

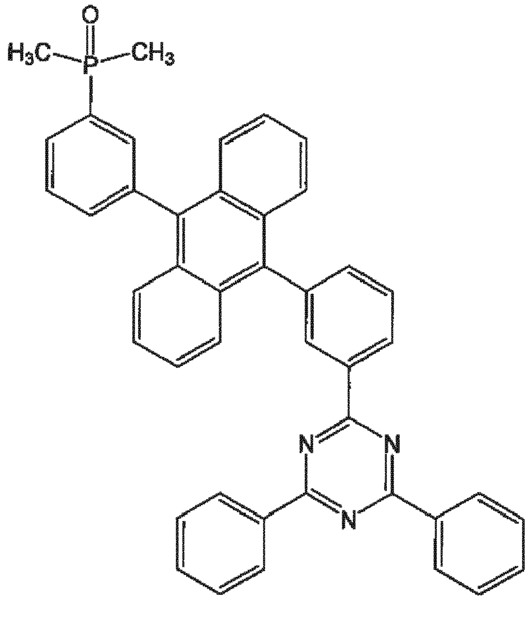

(E2).

The first electron transport matrix compound may have a LUMO energy level of ≤-2.0 eV. This means more negative as 2.0 eV below vacuum energy level that is arbitrarily taken as zero.

The LUMO energy level as referred to herein is the energy level in the absolute scale taking vacuum energy level as zero, computed by the TURBOMOLE V6.5 program package using the DFT-HF hybrid functional B3LYP and def2-TZVP basis set.

The absolute value of the binding energy of the first electron transport matrix compound with a magnesium atom may be in the range of 19 to 44 kJ/mol.

The absolute value of the binding energy of the first electron transport matrix compound with a silver atom may be lower than the absolute value of the binding energy of the first electron transport matrix compound with a magnesium atom.

The dipole moment of the first electron transport matrix compound may be higher than 0.25 Debye.

All calculations are performed in the gas phase using the program package TURBOMOLE V6.5 applying the DFT-HF hybrid functional B3LYP with the def2-TZVP basis set. In addition, the dispersion correction named DFT-D3 with Becke-Johnson damping has been included, that is proposed by Stefan Grimme for density functional calculations (S. Grimme; J. Antony; S. Ehrlich; H. Krieg. A consistent and accurate ab initio parametrization of density functional dispersion correction (DFT-D) for the 94 elements H-Pu. *J. Chem. Phys.,* **132**, 154104, (2010)).

The geometries of all molecular structures of the first electron transport matrix compound and their metal complexes with Mg and Ag are optimized to minimize the total energy of the systems for the determination of the LUMO energy levels, the dipole moments and the binding energies.

The dipole moment $|\vec{\mu}|$ of a molecule containing N atoms is given by:

$$\vec{\mu} = \begin{pmatrix} \mu_x \\ \mu_y \\ \mu_z \end{pmatrix} = \sum_i^N q_i \vec{r_i} = \sum_i^N q_i \begin{pmatrix} x_i \\ y_i \\ z_i \end{pmatrix}$$

$$|\vec{\mu}| = \sqrt{\mu_x^2 + \mu_y^2 + \mu_z^2}$$

where $q_i$ and $\vec{r_i}$ are the partial charge and position of atom i in the molecule. The partial charges are obtained within a Mulliken population analysis. The atomic positions are taken from the optimized geometries of the molecular structures. If more than one conformation is viable, the conformation with the lowest total energy is selected to determine the dipole moment.

The binding energies *BDE* of the molecular structures with Mg or Ag were calculated according to the following formula:

$$BDE = E_{tot}(ETM) + E_{tot}(Metal) - E_{tot}(Complex)$$

Therein, $E_{tot}(ETM)$, $E_{tot}(Metal)$ and $E_{tot}(Complex)$ are the total energies of the optimized structures of the first electron transport matrix compound, the metal and the metal complexes, respectively.

It may be provided that the first electron transport matrix compound does not have the following structure:

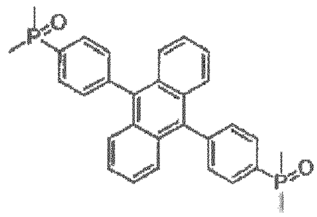

Metal salt

The metal salt may be an alkali metal salt, an alkaline earth metal salt or a rare earth metal salt, preferably a Li-, Na-, K-, Rb-, Cs-, Mg-, Ca-, Sr- or Ba-salt.

The metal salt may comprise a metal chelating anion, preferably selected from the group consisting of a phenolate, such as a phosphine oxide phenolate, and 8-hydroxyquinolinolate.

Especially, the metal salt may be selected from alkali metal salts and alkali metal complexes; preferably from lithium salts and lithium organic complexes; more preferably from lithium halides and lithium organic chelates; even more preferably from lithium fluoride, a lithium quinolinolate, lithium borate, lithium phenolate, lithium pyridinolate or from a lithium complex with a Schiff base ligand; most preferably,

- the lithium complex has the formula II, III or IV:

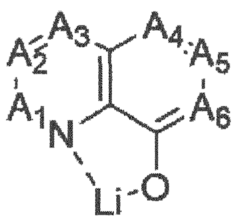 (II), 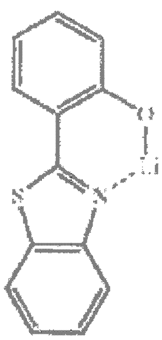 (III), 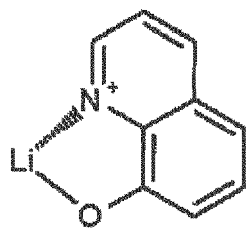 (IV)

wherein

$A_1$ to $A_6$ are same or independently selected from CH, CR, N, O;
R is same or independently selected from hydrogen, halogen, alkyl or aryl or heteroaryl with 1 to 20 carbon atoms; and more preferred $A_1$ to $A_6$ are CH,

- the borate based organic ligand is a tetra(1H-pyrazol-1-yl)borate,
- the phenolate is a 2-(pyridin-2-yl)phenolate, a 2-(diphenylphosphoryl)phenolate, an imidazol phenolate, 2-(pyridin-2-yl)phenolate or 2-(1-phenyl-1H-benzo[d]imidazol-2-yl)phenolate,
- the pyridinolate is a 2-(diphenylphosphoryl)pyridin-3-olate,
- the lithium Schiff base has the structure 100, 101, 102 or 103:

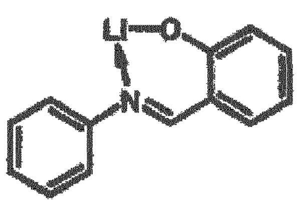
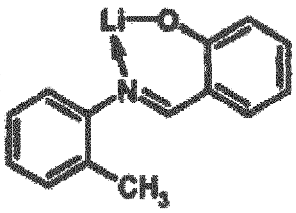
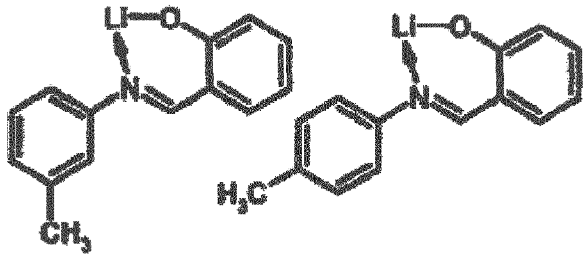

100 101 102 103

According to one embodiment of the invention, the organic semiconducting material of the present invention comprises a lithium organic complex, alternatively lithium 8-hydroxyquinolinolate (LiQ).

The metal salt may have the formula (2)

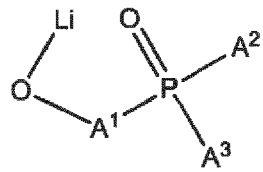

Formula (2)

wherein $A^1$ is a $C_6$-$C_{20}$ arylene and each of $A^2$-$A^3$ is independently selected from a $C_6$-$C_{20}$ aryl, wherein the aryl or arylene may be unsubstituted or substituted with groups comprising C and H or with a further LiO group, provided that the given C count in an aryl or arylene group includes also all substituents present on the said group.

The metal salt comprises a metal chelating anion, preferably selected from the group consisting of a phenolate, such as a phosphine oxide phenolate, and 8-hydroxyquinolinolate.

It may be provided that the metal salt is not lithium tetra(1H-pyrazol-1-yl)borate.

Organic electronic device

The organic electronic device may be an organic light emitting diode (OLED), especially a top emission organic light emitting diode.

The OLED may further comprise a second electron transport layer and a second emission layer, wherein the second electron transport layer is arranged between the second emission layer and the cathode, and the second electron transport layer comprises a second electron transport matrix material.

The second electron transport layer may comprise an electrical n-dopant. The electrical n-dopant in the second ETL may be selected from elemental electropositive metals, metal complexes and metal salts, especially may be LiQ.

The second electron transport layer may comprise a second electron transport matrix compound. The first electron transport matrix compound and the second electron transport matrix compound may be the same.

The OLED may further comprise a charge generating layer (CGL) arranged between the first and the second emission layer. The charge generating layer may consist of an electron generating sublayer (n-CGL) and a hole generating sublayer (p-CGL). The n-CGL may comprise a third electron transport matrix and a n-dopant. The n-dopant may be a redox n-dopant. The n-dopant may consist of metal salt or metal complex or of an elemental metal. The elemental metal may be Yb.

In one embodiment, the first electron transport matrix compound and the third electron transport matrix compound may be the same. It can be also provided that the second electron transport matrix compound and the third electron transport matrix compound are the same. In one embodiment, it may be also provided that the first electron transport matrix compound, the second electron transport matrix compound and the third electron transport matrix compound are the same.

It may be provided that an embodiment in which the first electron transport matrix compound has the following structure:

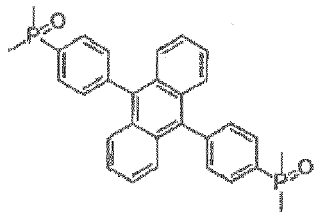

the metal salt is lithium tetra(1H-pyrazol-l-yl; the first electron transport matrix compound and the metal salt are present in a vol.-% ratio of 20:30; the cathode consists of an alloy of Ag and Mg with a Ag:Mg vol.-ratio of 85:85; and the cathode has a thickness of 11 nm is excluded.

Further layers

In accordance with the invention, the organic electronic device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

*Anode electrode*

Either a first electrode or a second electrode comprised in the inventive organic electronic device may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode electrode may also be formed using metals, typically silver (Ag), gold (Au), or metal alloys.

*Hole injection layer*

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10-8 to 10-3 Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2

eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Photoactive layer (PAL)*

The photoactive layer converts an electrical current into photons or photons into an electrical current.

The PAL may be formed on the HTL by vacuum deposition, spin coating, slot-die coat-ing, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

It may be provided that the photoactive layer does not comprise the first electron transport matrix compound.

The photoactive layer may be a light-emitting layer or a light-absorbing layer.

*Emission layer (EML)*

The EML may be formed on the HTL by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

It may be provided that the emission layer does not comprise the first electron transport matrix compound.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are $Ir(ppy)_3$ (ppy = phenylpyridine), Ir(ppy)2(acac), Ir(mpyp)3.

Examples of phosphorescent blue emitter dopants are F2Irpic, (F2ppy)2Ir(tmd) and $Ir(dfppz)_3$ and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function. The hole blocking layer may be the inventive organic semiconductor layer comprising or consisting of the first electron transport matrix compound as defined above.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

The hole blocking layer may also be described as a-ETL or auxiliary ETL.

According to an embodiment, a hole blocking layer is arranged between the at least one photoactive layer and the first electron transport layer.

According to an embodiment, a hole blocking layer is arranged between the at least one photoactive layer and the first electron transport layer.

*Electron transport layer (ETL)*

The organic electronic device according to the present invention comprises a first electron transport layer as characterized herein in direct contact with the cathode. In addition, the organic electronic device according to the invention may comprise at least one further electron transport layers, such as a second electron transport layer.

The second electron transport layer of the organic electronic device may comprise the first electron transport matrix compound which is also comprised in the first electron transport layer. The second electron transport layer may comprise, besides or instead of first electron transport matrix compound, further ETM materials known in the art.

Further, the second electron transport layer may comprise one or more n-type dopants. The additive may be an n-type dopant. The additive can be alkali metal, alkali metal compound, alkaline earth metal, alkaline earth metal compound, transition metal, transition metal compound or a rare earth metal. In another embodiment, the metal can be one selected from a group consisting of Li, Na, K, Rb, Cs, Mg, Ca, Sr, Ba, La, Ce, Sm, Eu, Tb, Dy, and Yb. In another emdodiment, the n-type dopant can be one selected from a group consisting of Cs, K, Rb, Mg, Na, Ca, Sr, Eu and Yb. In an embodiment the alkali metal compound may be 8-Hydroxyquinolinolato-lithium (LiQ), Lithium tetra(1H-pyrazol-1-yl)borate or Lithium 2-(diphenylphosphoryl)phenolate. Suitable compounds for the ETM are not particularly limited. In

one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

*Electron injection layer (EIL)*

In organic electronic devices according to the prior art an EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

Such an electron injection layer is not present in the organic electronic device according to the present invention between the first electron transport layer and the cathode since the first electron transport layer is in direct contact with the cathode.

*Charge generation layer (CGL)*

The charge generation layer (CGL) may comprise a p- type charge generation layer (p-CGL) and an n-type charge generation layer (n-CGL). An interlayer may be arranged between the p-CGL and the -n-CGL.

Typically, the charge generation layer is a pn junction joining an n-type charge generation layer (electron generating layer) and a hole generating layer. The n-side of the pn junction generates electrons and injects them into the layer which is adjacent in the direction to the anode. Analogously, the p-side of the p-n junction generates holes and injects them into the layer which is adjacent in the direction to the cathode.

Charge generating layers are used in tandem and stacked devices, for example, in tandem or stacked OLEDs comprising, between two electrodes, two or more emission layers. In a tandem or stacked OLED comprising two emission layers, the n-type charge generation layer provides electrons for the first light emission layer arranged near the anode, while the hole generating layer provides holes to the second light emission layer arranged between the first emission layer and the cathode.

Suitable matrix materials for the hole generating layer may be materials conventionally used as hole injection and/or hole transport matrix materials. Also, p-type dopant used for the hole generating layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, FeCl3, FeF3, and SbCl5. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB). The p-type charge generation layer may consist of CNHAT.

The n-type charge generating layer may comprise an electron transport compound that is the same as the first electron transport matrix compound. The n-type charge generation layer can be layer of a neat n-type dopant, for example of a metal, or can consist of an organic matrix material doped with the n-type dopant. In one embodiment, the n-type dopant can be alkali metal, alkali metal compound, alkaline earth metal, alkaline earth metal compound, a transition metal, a transition metal compound or a rare earth metal. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Li, Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting of triazine compounds, hydroxyquinoline derivatives like tris(8-hydroxyquinoline)aluminum, benzazole derivatives, and silole derivatives.

The hole generating layer may be arranged in direct contact to the n-type charge generation layer.

Organic light-emitting diode

The organic electronic device according to the invention may be an organic light-emitting device.

According to one aspect of the present invention, there is provided an organic light-emitting diode (OLED) comprising: a substrate; an anode electrode formed on the substrate; a hole injection layer, a hole transport layer, an emission layer, the first electron transport layer and the cathode electrode.

According to another aspect of the present invention, there is provided an OLED comprising: a substrate; an anode electrode formed on the substrate; a hole injection layer, a hole transport layer, an electron blocking layer, an emission layer, a hole blocking layer, the first electron transport layer and the cathode electrode.

According to one aspect, the OLED can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a second emission layer, the second emission layer is adjacent arranged to a second electron transport layer, the second electron transport layer is adjacent arranged to an n-type charge generation layer, the n-type charge generation layer is adjacent arranged to a hole generating layer, the hole generating layer is adjacent arranged to a second hole transport layer, the second hole transport layer is adjacent arranged to a second electron blocking layer, the second electron blocking layer is adjacent arranged to a first emission layer, the first emission layer is adjacent arranged to a hole blocking layer, the hole blocking layer is adjacent arranged to the first electron transport layer that is adjacent arranged to a cathode.

For example, the OLED according to Fig. 2 may be formed by a process, wherein on a substrate (110), an anode (120), a hole injection layer (130), a hole transport layer (140), an electron blocking layer (145), an emission layer (150), a hole blocking layer (155), an electron transport layer (160) and the cathode electrode (190) are subsequently formed in that order.

Organic electronic device

The organic electronic device according to the invention may be a light emitting device, or a photovoltaic cell, and preferably a light emitting device.

According to another aspect of the present invention, there is provided a method of manufacturing an organic electronic device, the method using:

- at least one deposition source, preferably two deposition sources and more preferred at least three deposition sources.

The methods for deposition that can be suitable comprise:

- deposition via vacuum thermal evaporation;
- deposition via solution processing, preferably the processing is selected from spin-coating, printing, casting; and/or
- slot-die coating.

According to various embodiments of the present invention, there is provided a method using:

- a first deposition source to release the first electron transport matrix compound, and
- a second deposition source to release the metal salt;

the method comprising the steps of forming the organic semiconductor layer; whereby for an organic light-emitting diode (OLED):

- the organic semiconductor layer is formed by releasing the first electron transport matrix compound from the first deposition source and the metal salt from the second deposition source.

According to various embodiments of the present invention, the method may further include forming on the anode electrode, an emission layer and at least one layer selected from the group consisting of forming a hole injection layer, forming a hole transport layer, or forming a hole blocking layer, between the anode electrode and the first electron transport layer.

According to various embodiments of the present invention, the method may further include the steps for forming an organic light-emitting diode (OLED), wherein

- on a substrate a first anode electrode is formed,
- on the first anode electrode an emission layer is formed,

- on the emission layer an electron transport layer stack is formed, optionally a hole blocking layer is formed on the emission layer and an electron transport layer is formed,

- and finally a cathode electrode is formed,

- optional a hole injection layer, a hole transport layer, and a hole blocking layer, formed in that order between the first anode electrode and the emission layer.

According to various embodiments, the OLED may have the following layer structure, wherein the layers having the following order:
anode, hole injection layer, first hole transport layer, second hole transport layer, emission layer, optional hole blocking layer, first electron transport layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application. More preferably, the electronic device is a display device.

In one embodiment, the organic electronic device according to the invention may further comprise a layer comprising a radialene compound and/or a quinodimethane compound.

In one embodiment, the radialene compound and/or the quinodimethane compound may be substituted with one or more halogen atoms and/or with one or more electron withdrawing groups. Electron withdrawing groups can be selected from nitrile groups, halogenated alkyl groups, alternatively from perhalogenated alkyl groups, alternatively from perfluorinated alkyl groups. Other examples of electron withdrawing groups may be acyl, sulfonyl groups or phosphoryl groups.

Alternatively, acyl groups, sulfonyl groups and/or phosphoryl groups may comprise halogenated and/or perhalogenated hydrocarbyl. In one embodiment, the perhalogenated hydrocarbyl may be a perfluorinated hydrocarbyl. Examples of a perfluorinated hydrocarbyl can be perfluormethyl, perfluorethyl, perfluorpropyl, perfluorisopropyl, perfluorobutyl, perfluorophenyl, perfluorotolyl; examples of sulfonyl groups comprising a halogenated hydrocarbyl may be trifluoromethylsulfonyl, pentafluoroethylsulfonyl, pentafluorophenylsulfonyl, heptafluoropropylsufonyl, nonafluorobutylsulfonyl, and like.

In one embodiment, the radialene and/or the quinodimethane compound may be comprised in a hole injection, hole transporting and/or a hole generation layer.

In one embodiment, the radialene compound may have Formula (XX) and/or the quinodimethane compound may have Formula (XXIa) or (XXIb):

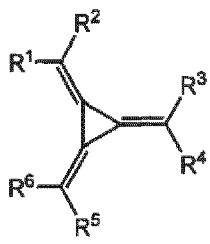 (XX) 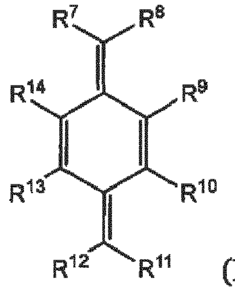 (XXIa) 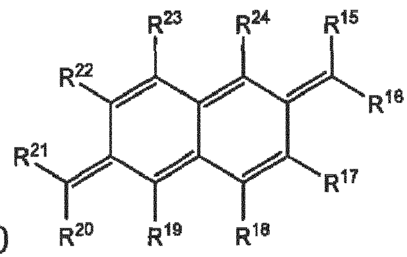 (XXIb),

wherein (as an exception different to the description above) $R^1$, $R^2$, $R^3$, $R^4$, $R^5$, $R^6$, $R^7$, $R^8$, $R^{11}$, $R^{12}$, $R^{15}$, $R^{16}$, $R^{20}$, $R^{21}$ are independently selected from above mentioned electron withdrawing groups and $R^9$, $R^{10}$, $R^{13}$, $R^{14}$, $R^{17}$, $R^{18}$, $R^{19}$, $R^{22}$, $R^{23}$ and $R^{24}$ are independently selected from H, halogen and above mentioned electron withdrawing groups.

GENERAL DEFINITIONS

In the present specification, when a definition is not otherwise provided, an "alkyl group" may refer to an aliphatic hydrocarbon group. The alkyl group may refer to "a saturated alkyl group" without any double bond or triple bond. The term "alkyl" as used herein shall encompass linear as well as branched and cyclic alkyl. For example, $C_3$-alkyl may be selected from n-propyl and iso-propyl. Likewise, $C_4$-alkyl encompasses n-butyl, sec-butyl and t-butyl. Likewise, $C_6$-alkyl encompasses n-hexyl and cyclo-hexyl.

As used herein if not explicitly mentioned else, the asterisk symbol "*" represents a binding position at which the moiety labelled accordingly is bond to another moiety.

The subscribed number n in $C_n$ relates to the total number of carbon atoms in the respective alkyl, arylene, heteroarylene or aryl group.

The term "aryl" or "arylene" as used herein shall encompass phenyl ($C_6$-aryl), fused aromatics, such as naphthalene, anthracene, phenanthrene, tetracene etc.. Further encompassed are biphenyl and oligo- or polyphenyls, such as terphenyl, phenyl-substituted biphenyl, phenyl-substituted terphenyl (such as tetraphenyl benzole groups) etc.. "Arylene" respectively "heteroarylene", refers to groups to which two further moieties are attached. In the present specification, the term "aryl group" or "arylene group" may refer to a group comprising at least one hydrocarbon aromatic moiety, and all the elements of the hydrocarbon aromatic moiety may have p-orbitals which form conjugation, for example a phenyl group, a napthyl group, an anthracenyl group, a phenanthrenyl group, a pyrinyl group, a fluorenyl group and the like. Further encompoassed are spiro compounds in which two aromatic moieties are connected with each other via a spiro-atom, such as 9,9'-spirobi[9H-fluorene]yl. The aryl or arylene group may include a monocyclic or fused ring polycyclic (i.e., links sharing adjacent pairs of carbon atoms) functional group.

The term "heteroaryl" as used herein refers to aryl groups in which at least one carbon atom is substituted with a heteroatom. The term "heteroaryl" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, O and S. A heteroarylene ring may comprise at least 1 to 3 heteroatoms. Preferably, a heteroarylene ring may comprise at least 1 to 3 heteroatoms individually selected from N, S and/or O. Just as in case of "aryl"/"arylene", the term "heteroaryl" comprises, for example, spiro compounds in which two aromatic moieties are connected with each other, such as spiro[fluorene-9,9'-xanthene]. Further exemplary heteroaryl groups are diazine, triazine, dibenzofurane, dibenzothiofurane, acridine, benzoacridine, dibenzoacridine etc.

The term "alkenyl" as used herein refers to a group $-CR^1 = CR^2R^3$ comprising a carbon-carbon double bond.

The term "perhalogenated" as used herein refers to a hydrocarbyl group wherein all of the hydrogen atoms of the hydrocarbyl group are replaced by halogen (F, Cl, Br, I) atoms.

The term "alkoxy" as used herein refers to a structural fragment of the Formula -OR with R being hydrocarbyl, preferably alkyl or cycloalkyl.

The term "thioalkyl" as used herein refers to a structural fragment of the Formula -SR with R being hydrocarbyl, preferably alkyl or cycloalkyl.

The subscripted number n in $C_n$-heteroaryl merely refers to the number of carbon atoms excluding the number of heteroatoms. In this context, it is clear that a $C_3$ heteroarylene group is an aromatic compound comprising three carbon atoms, such as pyrazol, imidazole, oxazole, thiazole and the like.

The term "heteroaryl" as used herewith shall encompass pyridine, quinoline, benzoquinoline, quinazoline, benzoquinazoline, pyrimidine, pyrazine, triazine, benzimidazole, benzothiazole, benzo[4,5]thieno[3,2-d]pyrimidine, carbazole, xanthene, phenoxazine, benzoacridine, dibenzoacridine and the like.

In the present specification, the term single bond refers to a direct bond.

The term "fluorinated" as used herein refers to a hydrocarbon group in which at least one of the hydrogen atoms comprised in the hydrocarbon group is substituted by a fluorine atom. Fluorinated groups in which all of the hydrogen atoms thereof are substituted by fluorine atoms are referred to as perfluorinated groups and are particularly addressed by the term "fluorinated".

In terms of the invention, a group is "substituted with" another group if one of the hydrogen atoms comprised in this group is replaced by another group, wherein the other group is the substituent.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

The term "contacting sandwiched" refers to an arrangement of three layers whereby the layer in the middle is in direct contact with the two adjacent layers.

With respect to the inventive electron transport layer stack the compounds mentioned in the experimental part are most preferred.

A lighting device may be any of the devices used for illumination, irradiation, signaling, or projection. They are correspondingly classified as illuminating, irradiating, signaling, and projecting devices. A lighting device usually consists of a source of optical radiation, a device that transmits the radiant flux into space in the desired direction, and a housing that joins the parts into a single device and protects the radiation source and light-transmitting system against damage and the effects of the surroundings.

According to another aspect, the organic electroluminescent device according to the present invention comprises two or three or more emission layers. An OLED comprising more than one emission layer is also described as a tandem OLED or stacked OLED.

The organic electroluminescent device (OLED) may be a bottom- or top-emission device. The organic electroluminescent device (OLED) may emit the light trough a transparent anode or through a transparent cathode.

Another aspect is directed to a device comprising at least one organic electroluminescent device (OLED).

A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural Formula.

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt.-%", "percent by weight", "% by weight", and variations thereof refer to a composition, component, substance or agent as the weight of that component, substance or agent of the respective electron transport layer divided by the total weight of the respective electron transport layer thereof and multiplied by 100. It is under-stood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about $\geq$ 380 nm to about $\leq$ 780 nm.

Preferably, the first electron transport layer is essentially non-emissive or non-emitting.

The operating voltage, also named U, is measured in Volt (V) at 10 milliAmpere per square centimeter (mA/cm2).

The candela per Ampere efficiency, also named cd/A efficiency is measured in candela per ampere at 10 milliAmpere per square centimeter (mA/cm2).

The external quantum efficiency, also named EQE, is measured in percent (%).

The color space is described by coordinates CIE-x and CIE-y (International Commission on Illumination 1931). For blue emission the CIE-y is of particular importance. A smaller CIE-y denotes a deeper blue color. Efficiency values are compared at the same CIE-y.

The highest occupied molecular orbital, also named HOMO, and lowest unoccupied molecular orbital, also named LUMO, are measured in electron volt (eV).

The term "OLED", "organic light emitting diode", "organic light emitting device", "organic optoelectronic device" and "organic light-emitting diode" are simultaneously used and have the same meaning.

The term "life-span" and "lifetime" are simultaneously used and have the same meaning.

The anode and cathode may be described as anode electrode / cathode electrode or anode electrode / cathode electrode or anode electrode layer / cathode electrode layer.

Room temperature, also named ambient temperature, is 23° C.

Hereinafter, the embodiments are illustrated in more detail with reference to examples. However, the present disclosure is not limited to the following examples. Reference will now be made in detail to the exemplary aspects.

## DESCRIPTION OF THE DRAWINGS

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments

according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an organic electronic device, according to an exemplary embodiment of the present invention;

FIG. 2 is a schematic sectional view of an organic light-emitting diode (OLED), according to an exemplary embodiment of the present invention;

FIG. 3 is a schematic sectional view of an OLED, according to an exemplary embodiment of the present invention.

FIG. 4 is a schematic sectional view of an OLED comprising a charge generation layer and two emission layers, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device 100, according to an exemplary embodiment of the present invention. The organic electronic device 100 includes a substrate 110, an anode 120, a photoactive layer (PAL) 125, the first electron transport layer 160. The first electron transport layer 160 is formed on the PAL 125. Onto the organic semiconductor layer 160, a cathode 190 is disposed.

FIG. 2 is a schematic sectional view of an organic light-emitting diode (OLED) 100, according to an exemplary embodiment of the present invention. The OLED 100 includes a substrate 110, an anode 120, a hole injection layer (HIL) 130, a hole transport layer (HTL) 140, an emission layer (EML) 150, the first electron transport layer (ETL) 160. The first electron transport layer (ETL) 160 is formed on the EML 150. Onto the electron transport layer (ETL) 160, the cathode 190 is disposed.

Instead of a single electron transport layer 160, optionally an electron transport layer stack (ETL) can be used.

Fig. 3 is a schematic sectional view of an OLED 100, according to another exemplary embodiment of the present invention. Fig. 3 differs from Fig. 2 in that the OLED 100 of Fig. 3 comprises an electron blocking layer (EBL) 145 and a hole blocking layer (HBL) 155.

Referring to Fig. 3, the OLED 100 includes a substrate 110, an anode 120, a hole injection layer (HIL) 130, a hole transport layer (HTL) 140, an electron blocking layer (EBL) 145, an emission layer (EML) 150, a hole blocking layer (HBL) 155, an electron transport layer (ETL) 160, and a cathode electrode 190.

In one embodiment, the ETL comprises a compound of Formula (1).

Fig. 4 is a schematic sectional view of an OLED 100, according to another exemplary embodiment of the present invention. Fig. 4 differs from Fig. 3 in that the OLED 100 of Fig. 4 further comprises a charge generation layer (CGL) and a second emission layer (151).

Referring to Fig. 4, the OLED 100 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a second electron transport layer (ETL) 160, an n-type charge generation layer (n-type CGL) 185, a hole generating layer (p-type charge generation layer; p-type GCL) 135, a second hole transport layer (HTL) 141, a second electron blocking layer (EBL) 146, a second emission layer (EML) 151, a second hole blocking layer (EBL) 156, a first electron transport layer (ETL) 161 and a cathode 190.

While not shown in Fig. 1, Fig. 2, Fig. 3 and Fig. 4, a sealing layer may further be formed on the cathode electrodes 190, in order to seal the OLEDs 100. In addition, various other modifications may be applied thereto.

Hereinafter, the embodiments are illustrated in more detail with reference to examples. However, the present disclosure is not limited to the following examples.

DETAILED DESCRIPTION

The invention is furthermore illustrated by the following examples which are illustrative only and non-binding.

EXPERIMENTAL PART

Compounds E1 and E2 are described in WO2018/215355 and WO2020/120793.

General procedure for fabrication of OLEDs

*Inventive compounds E1 and E2*

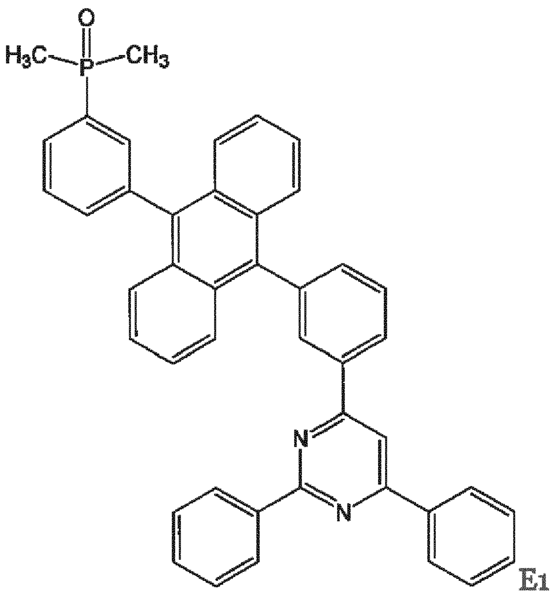

E1

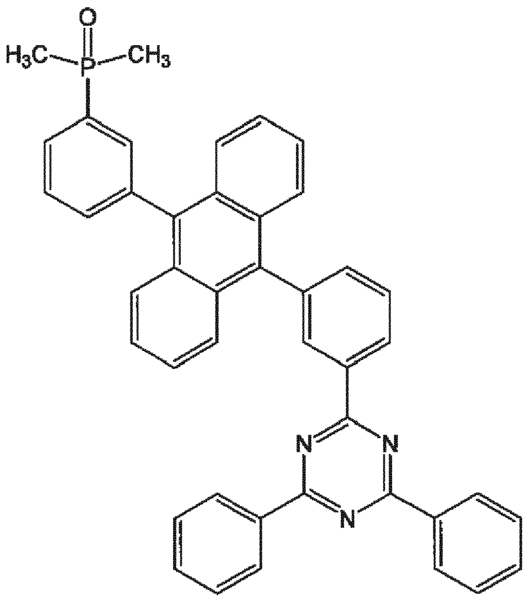

E2.

*Comparative compounds C1 to C3*

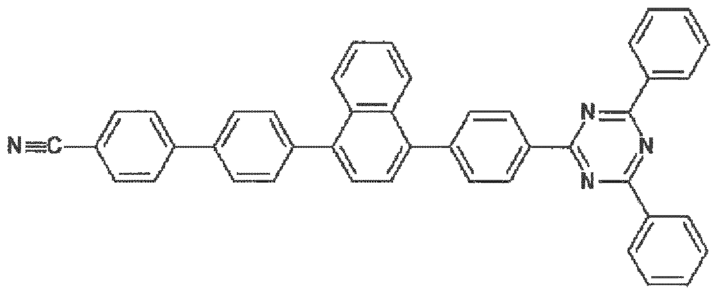

C1 CAS 2032421-37-5

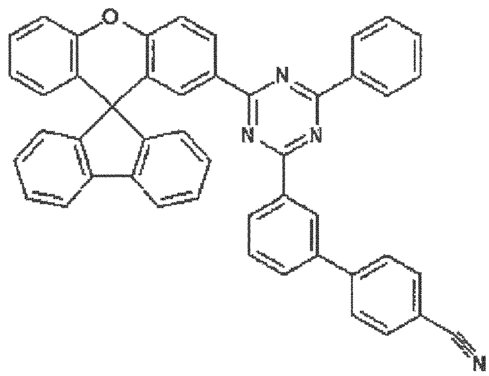

C2 CAS 2106888-25-7

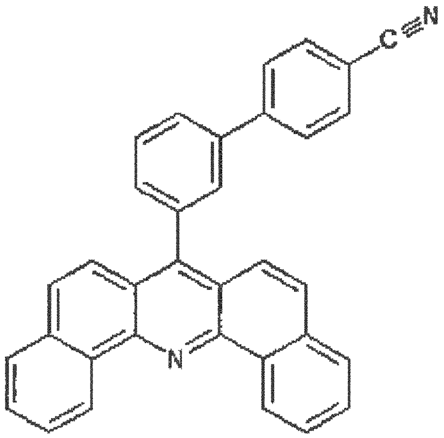

C3 CAS 2507517-91-9

*Support materials*

Supporting materials for device experiments

F1 is

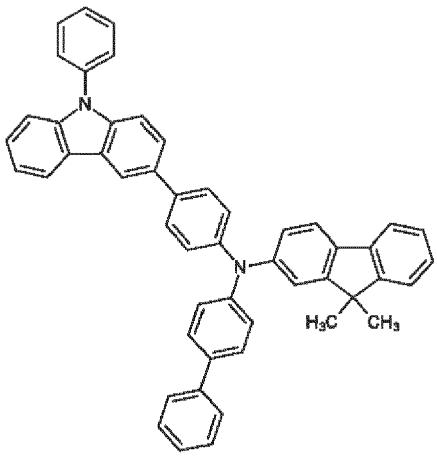

CAS 1242056-42-3

F2 is

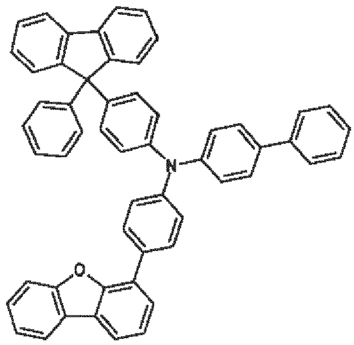

CAS 1824678-59-2

F3 is

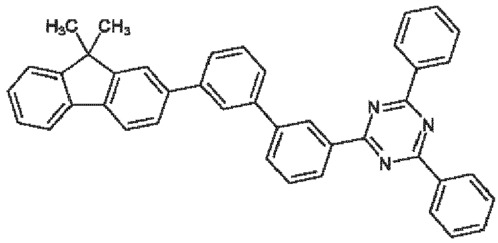

CAS 1955543-57-3

PD1 is

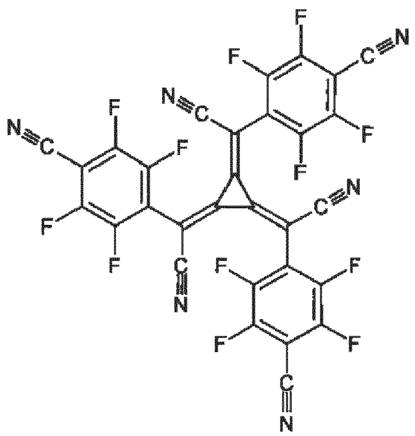

CAS 1224447-88-4

LiQ is lithium 8-hydroxyquinolinolate, CAS 850918-68-2

H09 is an emitter host and BD200 is a blue fluorescent emitter dopant, both commercially available from SFC, Korea.

*Preparation of the model blue OLED device*

The device was made by depositing a 10 nm hole injection layer of F1 doped with PD1 (matrix to dopant weight ratio of 98:2 vol%) onto an glass substrate provided with the silver anode, followed by a 125 nm thick undoped hole transport layer of F1. A 5 nm layer electron blocking layer of F2 was deposited on the HTL. Subsequently, a blue fluorescent emitting layer of emitter host H09 (Sun Fine Chemicals) doped with BD200 (Sun Fine Chemicals) (99:1 vol%) was deposited with a thickness of 20 nm. On the emission layer, a 5 nm layer made of F3 was deposited as a hole blocking layer. A 31 nm layer electron transport layer made of the tested compound and LiQ was co-deposited in volume ratio 50:50 on the HBL. Subsequently, a 13 nm thick cathode consisting of a silver-magnesium alloy in a volume ratio 90:10 was deposited on the ETL. In comparative devices, a 2 nm thick electron injection layer was deposited on the ETL before deposition of the Ag-Mg cathode. All depositions were made by vacuum thermal evaporation.

Table 1a schematically describes the model device.

Table 1a

| Layer | Material | Volume % | d (nm) |
|---|---|---|---|
| Cap layer | F1 | 100 | 75 |
| Cathode | Ag:Mg | 90:10 | 13 |
| EIL | Yb | 100 | 2 (comparative) or 0 (inventive) |
| ETL1 | Various ETM:LiQ | 50:50 | 31 |
| HBL | F3 | 100 | 5 |
| EML1 | H09:BD200 | 99:1 | 20 |
| EBL | F2 | 100 | 5 |
| HTL1 | F1 | 100 | 125 |
| HIL | F1:PD1 | 92:8 | 10 |
| Anode | Ag | 100 | 100 |

*Technical effect*

Surprisingly, it was found that the organic electronic device in accordance with the invention without the thin EIL show improved efficiency while keeping the operational voltage basically constant.

The results are shown in Table 2

Table 2

| ETL matrix | EIL nm | CIEy | Rel. voltage [%] | Rel. efficiency [%] | Voltage rise by 100-hour test [mV] |
|---|---|---|---|---|---|
| C1 | 0 | 0.044 | 103 | 101 | 37 |
| | 2 | 0.044 | 100 | 100 | 9 |
| C2 | 0 | 0.052 | 108 | 105 | 90 |
| | 2 | 0.053 | 100 | 100 | 20 |
| C3 | 0 | 0.045 | 108 | 97 | 731 |
| | 2 | 0.044 | 100 | 100 | 60 |
| E1 | 0 | 0.051 | 104 | 108 | 0 |
| | 2 | 0.051 | 100 | 100 | 0 |
| E2 | 0 | 0.046 | 103 | 108 | 13 |
| | 2 | 0.049 | 100 | 100 | 12 |

Inventive devices without the thin Yb EIL show improved efficiency while keeping the operational voltage during 100-hour test at current density 30 $mA/cm^2$ basically constant. Desisting from the Yb EIL in comparative devices (that lack the phosphine oxide ETL matrix) results in decreased voltage stability during the 100-hour test.

The features disclosed in the foregoing description and in the dependent claims may, both separately and in any combination thereof, be material for realizing the aspects of the disclosure made in the independent claims, in diverse forms thereof.

## Claims

1. An organic electronic device comprising an anode, a cathode, a first emission layer and a first electron transport layer, wherein

   - the first emission layer is arranged between the anode and the cathode;
   - the first electron transport layer is arranged between first emission layer and the cathode;
   - the first electron transport layer comprises a first electron transport matrix compound and a metal salt;
   - the first electron transport matrix compound comprises a phosphine oxide group;
   - the cathode comprises silver and/or a silver-containing alloy; and

- the first electron transport layer is in direct contact with the cathode.

2. The organic electronic device according to claim 1, wherein the cathode has a thickness from 1 to 20 nm.

3. The organic electronic device according to claim 1 or 2, wherein the cathode comprises silver in an amount of at least 90 vol% with respect to the total volume of the cathode.

4. The organic electronic device according to any of the preceding claims, wherein the cathode comprises a Mg-Ag alloy.

5. The organic electronic device according to any of the preceding claims, wherein the first electron transport layer has a thickness of more than 5 nm.

6. The organic electronic device according to any of the preceding claims, wherein the first electron transport matrix compound comprises exactly one phosphine oxide group.

7. The organic electronic device according to any of the preceding claims, wherein the first electron transport matrix compound comprises at least one aromatic heterocyclic group.

8. The organic electronic device according to claim 7, wherein the aromatic heterocyclic group comprises at least one nitrogen atom, preferably at least two nitrogen atoms.

9. The organic electronic device according to claim 7 or 8, wherein the aromatic heterocyclic group is selected from the group consisting of diazine, triazine, diazanaphtalene, diazaanthracene and diazaphenanthrene.

10. The organic electronic device according to any of the preceding claims, wherein the phosphine oxide group comprises a P=O moiety directly bonded to two $sp^3$ hybridized C-atoms.

11. The organic electronic device according to any of the preceding claims, wherein the phosphine oxide group is a dialkyl phosphine oxide group.

12. The organic electronic device according to any of the preceding claims, wherein the metal salt is an alkali metal salt, an alkaline earth metal salt or a rare earth metal salt, preferably a Li-, Na-, K-, Rb-, Cs-, Mg-, Ca-, Sr- or Ba-salt.

13. The organic electronic device according to any of the preceding claims, wherein the metal salt comprises a metal chelating anion, preferably selected from the group consisting of a phenolate, such as a phosphine oxide phenolate, and 8-hydroxyquinolinolate.

14. The organic electronic device according to any of the preceding claims, wherein the organic electronic device is an organic light emitting diode, especially a top emission organic light emitting diode.

15. A display device comprising the organic electronic device according to claim 14.

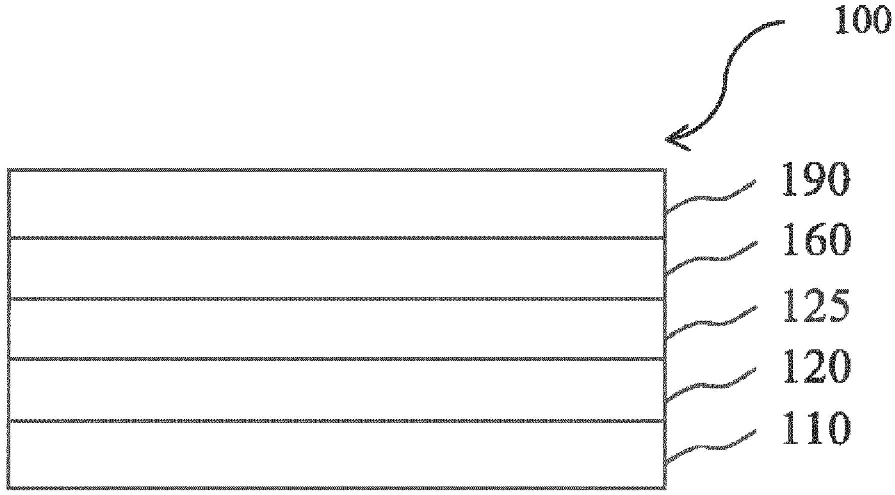


Fig.1

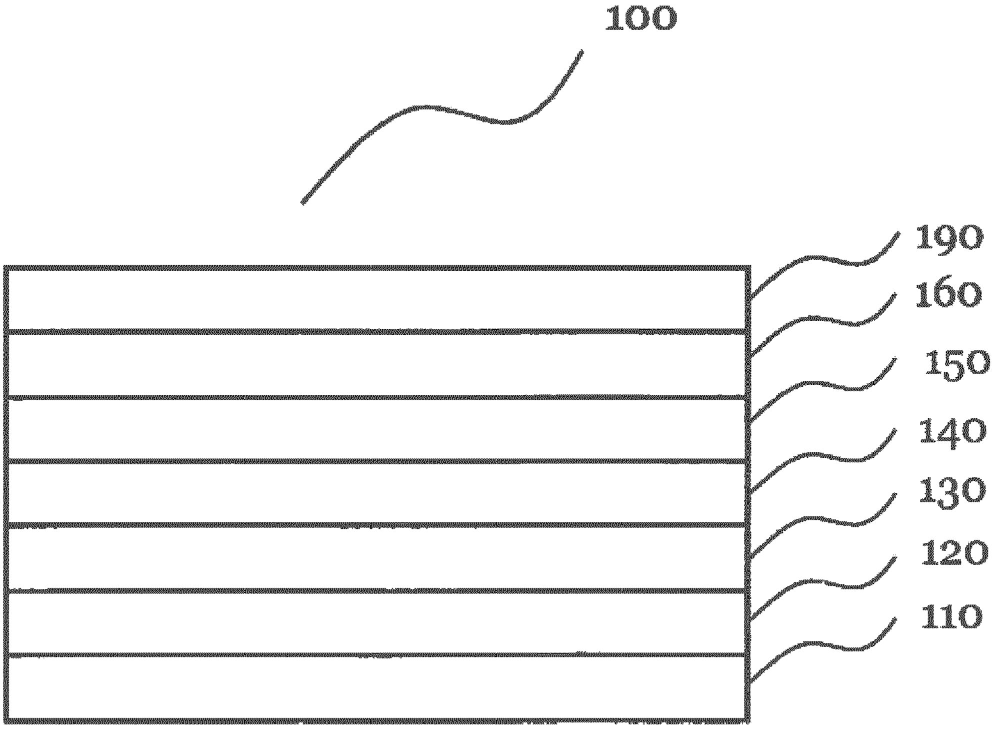


Fig. 2

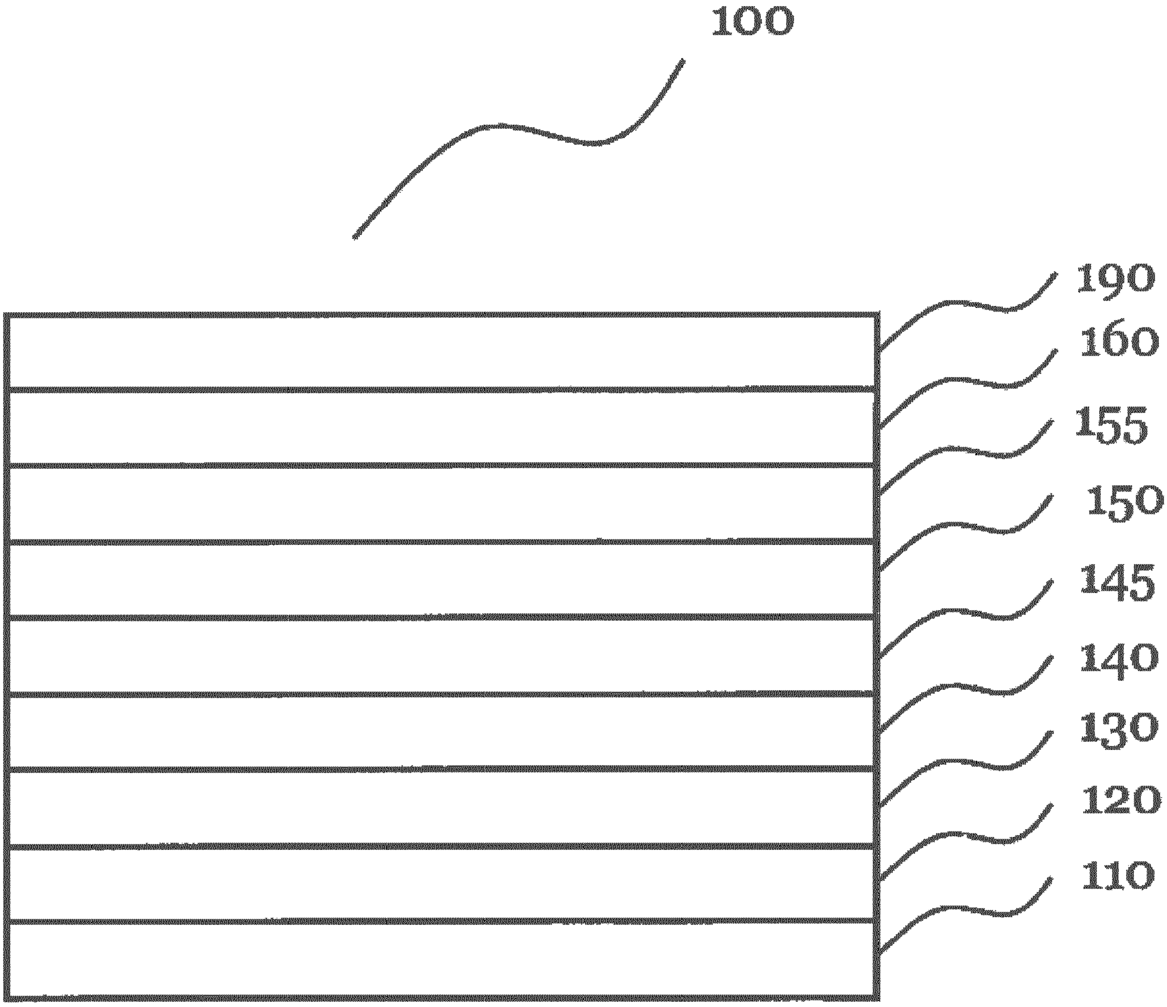


Fig. 3

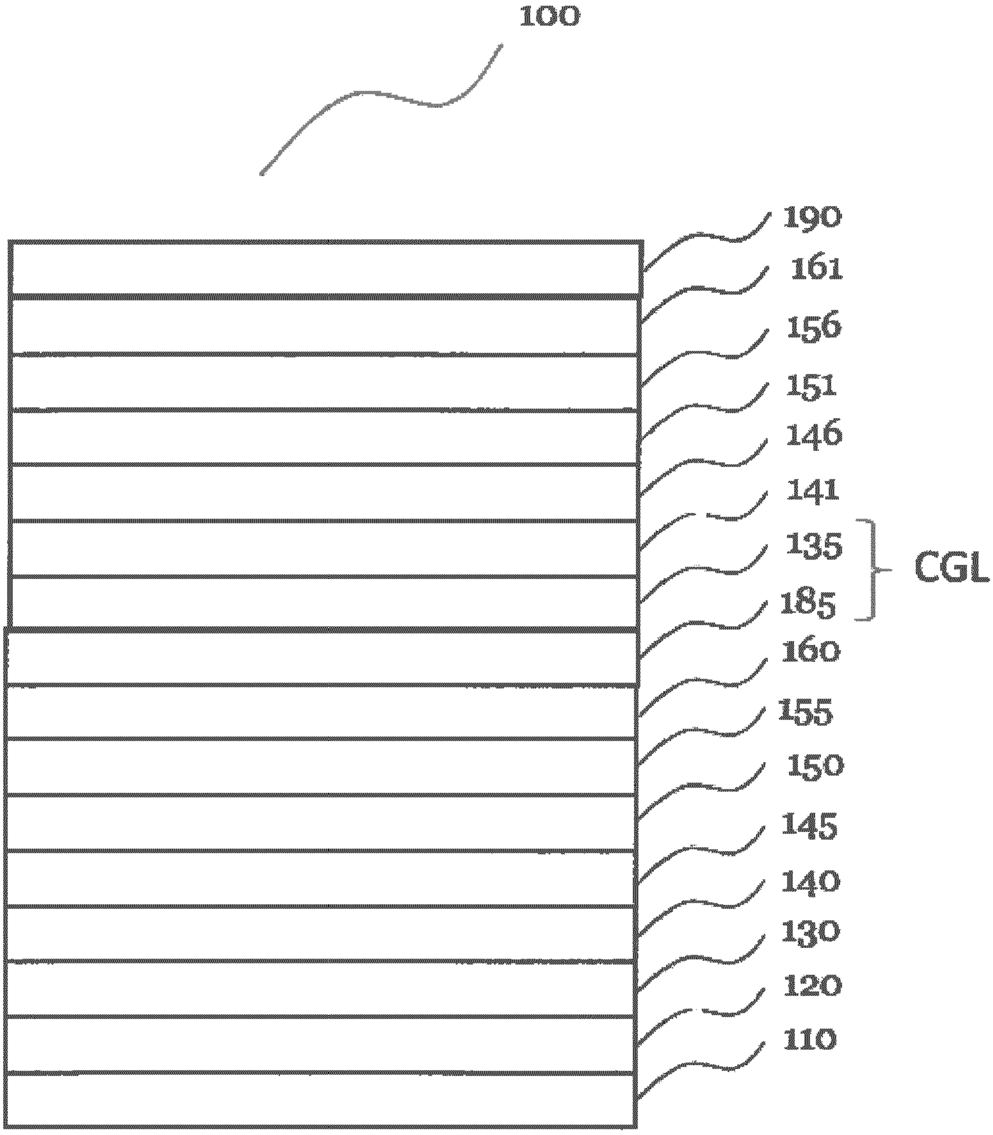
100
190
161
156
151
146
141
135
185
CGL
160
155
150
145
140
130
120
110

Fig. 4

Europäisches Patentamt
European Patent Office
Office européen des brevets

# EUROPEAN SEARCH REPORT

Application Number
EP 22 18 6607

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 407 401 A1 (NOVALED GMBH [DE]) 28 November 2018 (2018-11-28) * paragraph [0292] - paragraph [0321]; claims 1-19; tables 1-3 * * paragraph [0204] - paragraph [0236] * | 1-15 | INV. H01L51/50 H01L51/52 |
| X | EP 3 002 796 A1 (NOVALED GMBH [DE]) 6 April 2016 (2016-04-06) * paragraph [0163] - paragraph [0179]; claims 1-18; table 4 * * paragraph [0020] - paragraph [0078]; tables 1,2 * | 1-15 | |
| X | EP 2 963 696 A1 (NOVALED GMBH [DE]) 6 January 2016 (2016-01-06) * paragraph [0123] - paragraph [0143]; claims 1-19; tables 4-7 * * paragraph [0094] - paragraph [0113]; tables 1-3 * | 1-15 | |
| | | | TECHNICAL FIELDS SEARCHED (IPC) |
| | | | H01L |

The present search report has been drawn up for all claims

1

| Place of search | Date of completion of the search | Examiner |
|---|---|---|
| The Hague | 21 December 2022 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 22 18 6607

This annex lists the patent family members relating to the patent documents cited in the above-mentioned European search report. The members are as contained in the European Patent Office EDP file on
The European Patent Office is in no way liable for these particulars which are merely given for the purpose of information.

21-12-2022

| Patent document cited in search report | Publication date | Patent family member(s) | Publication date |
|---|---|---|---|
| EP 3407401 A1 | 28-11-2018 | CN 110892545 A | 17-03-2020 |
| | | EP 3407401 A1 | 28-11-2018 |
| | | KR 20200008622 A | 28-01-2020 |
| | | US 2020095269 A1 | 26-03-2020 |
| | | WO 2018215355 A1 | 29-11-2018 |
| EP 3002796 A1 | 06-04-2016 | DE 112015004529 T5 | 14-06-2017 |
| | | EP 3002796 A1 | 06-04-2016 |
| | | US 2017301876 A1 | 19-10-2017 |
| | | WO 2016050882 A1 | 07-04-2016 |
| EP 2963696 A1 | 06-01-2016 | CN 106660947 A | 10-05-2017 |
| | | EP 2963696 A1 | 06-01-2016 |
| | | EP 3164898 A1 | 10-05-2017 |
| | | KR 20170028963 A | 14-03-2017 |
| | | TW 201609544 A | 16-03-2016 |
| | | US 2017170411 A1 | 15-06-2017 |
| | | WO 2016001283 A1 | 07-01-2016 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2722908 A1
- EP 1970371 A1
- WO 2013079217 A1
- WO 2018215355 A
- WO 2020120793 A

### Non-patent literature cited in the description

- *CHEMICAL ABSTRACTS,* 850918-68-2